# EUROPEAN PATENT APPLICATION

(11) **EP 2 107 039 A2**
(43) Date of publication of application: **07.10.2009**
(21) Application number: 09156790.9
(22) Date of filing: 31.03.2009
(51) Int. Cl.: B81B 3/00, B81B 7/00

(54) **Microelectromechanical thin film device of transition metal oxide, and manufacturing method thereof**

(30) Priority: 02.04.2008 IT TO20080257
(71) Applicant: Consiglio Nazionale delle Ricerche - INFM Istituto Nazionale per la Fisica della Materia, 16152 Genova (IT)
(72) Inventor: Pellegrino, Luca, I-17021, ALASSIO (Savona) (IT); Biasotti, Michele, I-16039, SESTRI LEVANTE (Genova) (IT); Siri, Antonio, Sergio, I-16167, GENOVA (IT)
(74) Representative: Deambrogi, Edgardo

(57) **Abstract**

Microelectromechanical device (MEMS) integrated on a crystalline oxide substrate (1) comprising: at least one suspended structure (6) able to deform by the application of an electric or magnetic field and a thin film structure (10) comprising at least one transition metal oxide (10) deposited on the suspended structure (6). The device is characterized by the fact that the suspended structure (6) comprises a bearing layer (4) of crystalline oxides.

## Description

The present invention regards microelectromechanical (MEMS) devices based on suspended structures, as defined in the preamble of claim 1. The invention also regards a fabrication method for these devices, as defined in the preamble of claim 5.

The applications of transition metal oxides (TMO) regards numerous fields, such as superconductivity, spintronics, optoelectronics, biology. Transition metal oxides are materials with multiple functional properties, like high temperature superconductivity, ferroelectricity, magnetism, piezoelectricity, dielectricity or semiconductivity.

Transition metal oxides can be easily grown in form of epitaxial thin films with a high degree of crystallinity, with an atomic scale control of thicknesses and interfaces.

Thus, monocrystalline structures whose physical properties vary depending on the selected layer can be realized. Furthermore, the presence of "perfect" interfaces between oxides having the same crystalline order, but different properties, involves the rising of new phenomenologies, of very recent investigation, analogue to those that brought to milestones in the field of traditional semiconductors. The physical properties of transition metal oxides mostly depend on the transition metal (i.e. Cu, Mn, Ti, Co, V, Fe ...), and in particular on the d orbitals of its cations.

In fact, the filling of the d band and the superposition among the d orbitals determine the intensities of the interactions occurring within the solid. These interactions have structural (phonon), magnetic (spin) or electric (electrons) origin. The complexity of these systems derives from the couplings among the interactions, that cause rather complex phase diagrams and unique phenomena such as high temperature superconductivity, colossal magnetoresistance, physical unhomogeneities at the nanometer scale level.

The material deformation is a parameter that can be employed to modify the superposition among the atomic orbitals and thus to vary the resistive, magnetic and optical properties.

The control of the physical state of a thin film or of the interfaces of polyfunctional epitaxial multilayers of transition metal oxides by an external deformation, controllable, for instance by an electric bias, has led to research on systems showing high efficiency in terms of voltage-deformation yield, and the possibility of obtaining a high degree of integration.

Microelectromechanical systems (MEMS) and nanoelectromechanical systems (NEMS) are miniaturized embedded systems comprising one or more components or micromechanical structures. Nowadays MEMS are employed in industrial, automotive, defence applications, etc.

MEMS technology exploits the mechanical properties of silicon to create suspended micro and nanometric structures, that are moved by external electromagnetic fields. Thus MEMS technology is based on silicon compatible materials.

Hybrid MEMS structures based on silicon and transition metal oxides like piezocantilever, bolometers, infrared detectors or ferroelectric actuators, made of a silicon substrate onto which a transition metal oxide thin film is grown, have been made. For example, AFM (atomic force microscopy) cantilevers having piezoresistors made of doped silicon have been introduced long time ago: the cantilever deformation driven by external deformations produces a deformation of doped silicon regions, and said deformation varies the electrical resistance of said regions (strain gauge). Thus the cantilever deflection is converted in a modulation of the electrical resistance of the strain gauge.

Nevertheless, the use of silicon as structural element do not allow to grow compounds requiring highly oxidant environments or the use of the device in highly corrosive environments. Moreover, the necessity of depositing at high temperature (>400°C) and the incompatibility of chemical bond between transition metal oxides and silicon crystals, has made difficult the manufacturing of heteroepitaxial structures unless using particular "buffer" techniques, so far employed only for particular oxide compounds and that depress the crystalline quality of the film, specially if thin (< 20nm). Thus, it is not possible to study and use transition metal oxide films with high crystalline quality in connection with strain generating structures based on silicon.

Other insulating oxide substrates having enormous applicative interest, such us MgO, LaAlO₃, NdGaO₃, exist. Due to the different lattice parameters among these substrates, transition metal oxide films grown in the same experimental conditions exhibit different features, such as different magnetic ordering temperatures, structural (ferroelectric) and electrical (superconductivity, metal-insulator transition) transition temperatures.

The difference among samples behaviour is in part explained considering the effect of deformation (compressive and tensile) induced by the substrate and by the different microstructure of the films, due to the different interactions caused by the difference of used substrate. Although these studies allowed the comprehension of the potentialities of deformation for tuning the physical properties of these systems, the manufacturing of strain devices is unfeasible because the substrate can be deformed only by applying huge hydrostatic pressure on the sample, not by electrical or magnetic external fields. Furthermore, the application of hydrostatic pressures can be performed only within a laboratory.

Mixed systems with several phases has been recently introduced, in which the transition metal oxide film is actually made up of immiscible crystalline nanophases elastically coupled (e.g. BaTiO₃-CoFe₂O₄). These films have promising functionalities as strain devices, because the piezoelectric matrix of BaTi03 under the effect of an external electric field produces internal deformations, thus allowing the modulation of magnetic properties of the CoFe₂O₄ clusters, such as the reversal of the magnetization versus. However, this solution of strain device is limited only to few compounds and does not allow the modulation of the transport properties, such as the electric conductivity.

The most recent MEMS devices introduced in the field of transition metal oxides use nanotubes and nanowires made of oxides like ZnO, VO₂, Fe₃O₄ sintered by catalytic techniques. Nevertheless, catalytic techniques do not allow the manufacturing of movable and suspended thin film structures within these MEMS devices.

The object of the present invention is thus to propose a MEMS device able to operate at high temperatures and/or in highly corrosive environments and exploiting the physical properties of transition metal oxides.

Another object of the present invention is to propose a method for the manufacturing of a MEMS device as described above.

These and other objects are achieved with a device whose characteristics are defined in claim 1 and by a method whose characteristics are described in claim 5.

Particular embodiments are the subject of the dependent claims, whose content is to be understood as integral or integrating part of the present description.

Further characteristics and advantages of the invention will become clear from the detailed description which follows, provided purely by way of a non-limiting example, with reference to the appended drawings in which:
- figure 1 to 4 are longitudinal section views of different intermediate steps of a manufacturing method of the device according to the invention;
- figure 5 is a schematic representation of a device according to the invention.

In brief, the invention concerns a MEMS device entirely made of oxides. The invention concern the manufacturing of MEMS having micrometric or nanometric suspended crystalline structures, that are deformed by the application of electrical or magnetic fields. On these deformable structures thin films of transition metal oxides are deposited on which the deformation of the suspended structures acts by modifying their physical properties.

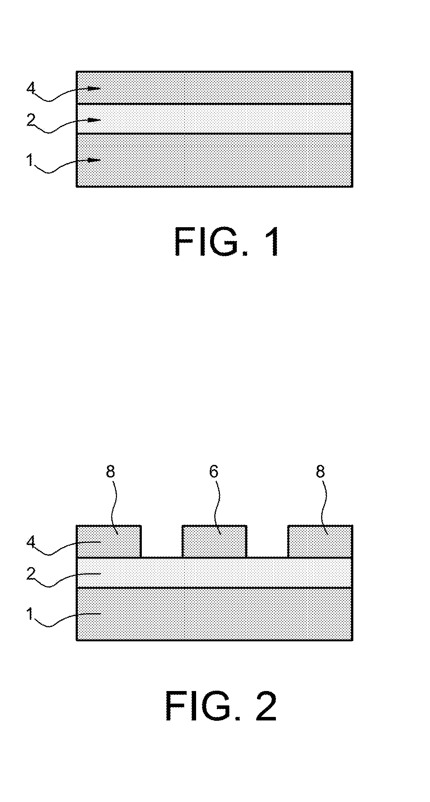

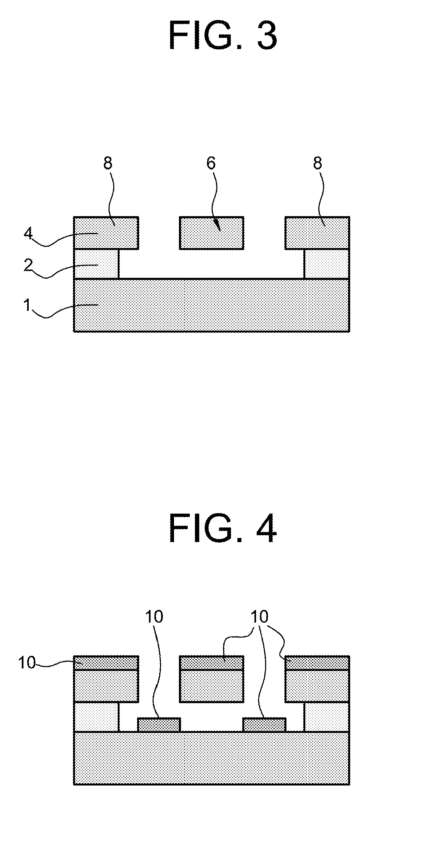

Referring to figures 1 to 4, a fabrication method of a MEMS device comprising suspended structures is described.

As shown in figure 1, a sacrificial layer 2, made for example of (La,Sr)MnO₃, is deposited on a supporting substrate 1 made of a crystalline oxide, such as strontium titanate (SrTiO₃). A bearing layer 4 of crystalline oxide, such as SrTiO₃, Pb(Zr,Ti)O₃ LaAlO₃, (Sr,Ba)TiO₃, TiO₂, NaNbO₃,NaTaO₃, (La,Sr)MnO₃, Fe₃O₄, SrRuO₃, YBa₂Cu₃O₇ is epitaxially grown on the sacrificial layer 2.

Alternatively, said bearing layer is a superlattice of crystalline oxides or an heterostructure.

Said bearing layer 4 has a thickness preferably comprised between 100nm and 1µm.

Subsequently, a standard photolithographic process (comprising a first step of definition of a mask, for example made up of positive or negative photoresist, and a second step of chemical wet etching, in liquid environment, or dry etching by reactive gases or ions) is carried out to obtain an intermediate region 6, substantially of rectangular section, placed between two lateral regions 8 of said bearing layer 4. Alternatively, said intermediate region 6 can have sections and geometries of different shapes.

Subsequently, the sacrificial layer 2 is removed by selective chemical etching (in liquid environment or by reactive gas) below the intermediate region 6 and partially below the lateral regions 8. In this way, the intermediate region 6 is transformed in a suspended structure. Alternatively, the sacrificial layer can be removed only below the intermediate region 6 and not below the lateral regions 8. Alternatively, the supporting substrate 1 can be also partially removed.

As an alternative way to the above described steps, the suspended structure 6 can be obtained without using the sacrificial layer 2. In this case, the bearing layer 4 is directly grown on the supporting substrate 1, the intermediate region 6 is obtained by using the photolithographic method and the supporting substrate 1 is removed below the intermediate region 6.

Subsequently, a transition metal oxide thin film structure 10, such as (La,Sr)MnO₃, (La,Sr)CoO₃, YBa₂Cu₃O₇₋ₓ, La₂₋ₓSrₓCuO₄, VO₂, is deposited. Alternatively, said transition metal oxide thin film structure 10 is epitaxially grown on the bearing layer 4.

Said thin film structure is for instance a thin film, a superlattice or a heterostructure.

In this way, a MEMS device having a suspended structure formed by a deformable monocrystalline substrate, coated with a transition metal oxide layer, is obtained. When the suspended structure deforms, the stress is transferred to the coating layer that changes its electrical properties with a high yield to deformation. This device is able to operate at high temperatures and in corrosive chemical environments because oxide materials are exclusively used.

The feasibility of the method according to the invention is due to the fact that different classes of transitions metal oxides have different sensitivities to chemical etching in liquid or gaseous environments. For instance, strontium titanate (SrTiO₃) is absolutely not etched by HCl-based liquid solutions, while it is etched by HF solutions. Instead, manganese oxides such as (La,Sr)MnO₃ (LSMO) show opposite behaviour. Thus, it is possible to manufacture suspended structure of manganese oxides using SrTiO₃ as sacrificial layer and suspended structures of SrTiO₃ using LSMO as sacrificial layer. Besides, when employing magnesium oxide as substrate material, it is possible to use acids like H₃PO₄ that strongly etches the oxide, that weakly etches the LSMO and that does not etch the SrTiO₃.

In some cases, (where the transition metal oxide film 10 is not etched by the etching process of the sacrificial layer 2) it is possible to deposit all the layers of the device in the first step and then proceed with the lithography and the suspension of the structure.

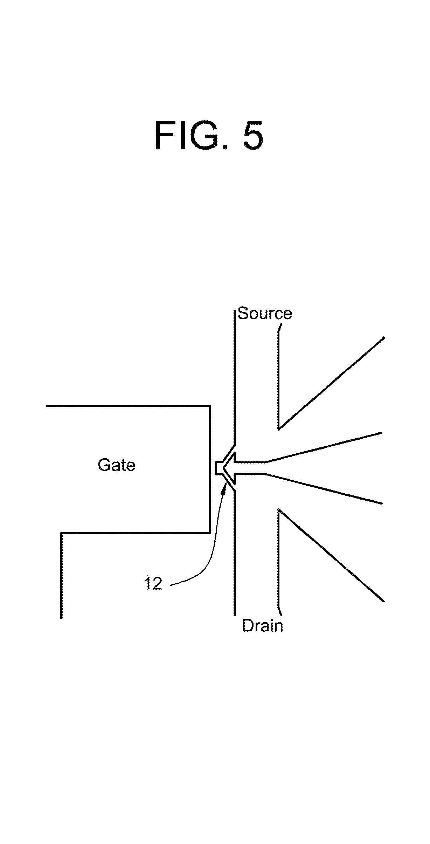

An example of MEMS device attainable according to the method of the invention is the superconducting switch reported in figure 5. The gate voltage deforms a suspended element 12 (for example a cantilever) advantageously made with SrTiO₃, onto which a superconductor, such as YBa₂Cu₃O₇₋ₓ, is epitaxially grown. The superconductor switches to the normal state at the point of maximum deformation and the circuit resistance between source and drain switches from zero to a finite value.

Therefore, it is possible to manufacture high frequency superconducting devices through the exploitation of the electromechanical couplings between the gate and the suspended element 12 where the oscillating voltages of the gate change the oscillation amplitude of the cantilever, tuning the transition entity of the superconducting film towards the resistive state. In case of nanometric cantilevers the resonance frequencies of the suspended element 12 can achieve values close to GHz.

Also, epitaxial thin film devices can be manufactured on the regions of maximum deformation of the suspended element 12 or in the regions of maximum elongation of the suspended element 12. In the first case, the deformation induced by the deformable substrate influences the device, changing its characteristics. In the second case, the device can be made oscillate in an external electric or magnetic field.

The opportunity of having a deformable crystalline substrate on which monocrystalline transition metal oxide thin films or multilayers can be properly grown, allows the manufacturing of devices or strain sensitive interfaces able to show the broadest response to the applied deformations.

Regarding integration on nanometric scale, the scaling of devices down to submicrometric scale allows both the increase of the number of devices integrable in a single chip, and the actuation (movement) of said devices using less power energy. Furthermore, the decreasing of the dimensions of the movable element allows to considerably increase the self-oscillation frequencies (resonance) of the devices up to values currently employed in wireless communications (GHz). The integration of oscillating elements in the RF frequency domain using high mobility thin film/multilayer (especially at low temperature) allows the manufacturing of devices suitable for the telecommunications field.

Naturally, the principle of the invention remaining the same, the embodiments and details of construction may be widely varied with respect to those described above and illustrated purely by way of a non-limiting example, without thereby departing from the scope of protection of the present invention, defined in the appended claims.

## Claims

1. Microelectromechanical device (MEMS) integrated on a crystalline oxide substrate (1) comprising:
- at least a suspended structure (6) able to deform by the application of an electric or magnetic field;
- a thin film structure (10) comprising at least one transition metal oxide (10) deposited on said suspended structure (6);
the device being **characterized in that** said suspended structure (6) comprises a supporting layer (4) of crystalline oxides.

2. Device according to claim 1, wherein said thin film structure is a thin film.

3. Device according to claim 1, wherein said thin film structure is a superlattice.

4. Device according to claim 1, wherein said thin film structure is a heterostructure.

5. Method for manufacturing a microelectromechanical device (MEMS) integrated on a crystalline oxide substrate (1) comprising the steps of:
- epitaxially growing a bearing layer (4) of crystalline oxide on the substrate (1);
- obtaining a suspended structure (6), able to deform by the application of an electric or magnetic field, said suspended structure (6) comprising a thin film structure of transition metal oxide (10).

6. Method according to claim 5, wherein the operation of obtaining a suspended structure (6) comprises the steps of:
- forming said suspended structure (6) starting from said bearing layer (4);
- depositing on said suspended structure (6) a thin film structure (10) comprising at least one transition metal oxide (10).

7. Method according to claim 6, wherein the operation of depositing on said suspended structure (6) a thin film structure (10) comprises the step of depositing a thin film.

8. Method according to claim 6, wherein the operation of depositing on said suspended structure (6) a thin film structure (10) comprises the step of depositing a superlattice.

9. Method according to claim 6, wherein the operation of depositing on said suspended structure (6) a thin film structure (10) comprises the step of depositing a heterostructure.

10. Method according to any claims 6 to 9, wherein the step of depositing a thin film structure of transition metal oxide (10) comprises the operation of epitaxially growing said thin film (10).

11. Method according to claim 5, wherein the operation of obtaining a suspended structure (6) comprises the steps of:
- depositing on the bearing layer (4) a thin film structure (10) comprising at least one transition metal oxide (10);
- forming said suspended structure (6) starting from said bearing layer (4).

12. Method according to any claims 5 to 11, wherein the operation of obtaining a suspended structure (6) comprises the steps of:
- defining an intermediate region (6) of said bearing layer (4);
- removing at least partially the substrate (1) below said intermediate region (6).

13. Method according to any claims 5 to 11, wherein the operation of obtaining a suspended structure (6) comprises the steps of:
- depositing on the substrate (1) a sacrificial layer (2), said sacrificial layer (2) being placed between the substrate (1) and the bearing layer (4);
- defining an intermediate region (6);
- removing said sacrificial layer (2) below said intermediate region (6).

14. Method according to claim 13, further comprising the step of removing a portion of the substrate (1) below the intermediate region (6).
